(19) **Europäisches Patentamt / European Patent Office / Office européen des brevets**

(11) **EP 2 796 885 B1**

(12) **FASCICULE DE BREVET EUROPEEN**

(45) Date de publication et mention de la délivrance du brevet:
**28.11.2018 Bulletin 2018/48**

(51) Int Cl.:
*G01R 19/25* (2006.01)  *G01R 21/133* (2006.01)
*G01R 29/04* (2006.01)  *G01R 35/04* (2006.01)

(21) Numéro de dépôt: **14165424.4**

(22) Date de dépôt: **22.04.2014**

(54) **Procédé et dispositif de détermination d'une énergie électrique consommée par une installation électrique**

Verfahren und Vorrichtung zur Bestimmung einer elektrischen Energie, die von einer elektrischen Anlage verbraucht wird

Method and device for determining the electric power consumed by an electric system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.04.2013 FR 1353726**

(43) Date de publication de la demande:
**29.10.2014 Bulletin 2014/44**

(73) Titulaire: **SAGEMCOM ENERGY & TELECOM SAS**
**92500 Rueil-Malmaison (FR)**

(72) Inventeur: **Teboulle, Henri**
**92500 RUEIL MALMAISON (FR)**

(74) Mandataire: **Cabinet Le Guen Maillet**
**3, impasse de la Vigie**
**CS 71840**
**35418 Saint-Malo Cedex (FR)**

(56) Documents cités:
**EP-A2- 0 420 545      WO-A1-2012/108993**
**WO-A1-2012/149194    DE-A1- 19 842 241**
**US-B1- 6 417 792      US-B1- 8 014 964**

**Description**

La présente invention concerne une détermination par un compteur électrique d'une énergie électrique consommée par une installation électrique supervisée par ledit compteur électrique, et plus particulièrement dans le cadre d'un signal de courant électrique pouvant prendre la forme d'un signal dissymétrique.

Des compteurs électriques permettent de calculer et fournir une information d'énergie consommée par des installations électriques respectives supervisées par lesdits compteurs électriques. De tels compteurs électriques disposent notamment d'étages de conversion analogique-numérique et d'étages d'amplification/atténuation à base d'amplificateurs opérationnels. Ceci entraîne que le signal de courant électrique fourni par un réseau d'alimentation électrique est vu par un tel compteur électrique potentiellement avec une composante continue, intrinsèque au compteur électrique, c'est-à-dire que cette composante continue est inexistante dans le signal de courant électrique fourni par le réseau d'alimentation électrique. Il convient de ne pas prendre en compte cette composante continue intrinsèque au compteur électrique dans le calcul de l'énergie consommée par l'installation électrique supervisée. Pour ce faire, le compteur électrique détermine une moyenne du signal de courant électrique et retire cette moyenne déterminée du calcul de l'énergie consommée. A noter que la composante continue intrinsèque au compteur électrique est en général à variation très lente EP 0420545 et DE19842241 divulguent des compteurs électriques.

Cette approche fonctionne bien lorsque le signal de courant électrique est symétrique, c'est-à-dire lorsque le signal de courant électrique oscille de manière équirépartie autour de la valeur nulle, ce qui est typiquement le cas d'un signal sinusoïdal centré autour de la valeur nulle. Dans cas, il n'y a en effet pas de composante continue intrinsèque au signal de courant électrique fourni par le réseau d'alimentation électrique.

Cependant, il existe des situations, comme celles définies dans certaines exigences normatives et/ou spécifications de fournisseurs d'énergie (demi-onde de courant définie dans la norme NF-EN 50470-3:2007, ou autre signal dissymétrique, potentiellement sporadique et à taux de présence faible), des compteurs électriques, dans lesquelles le signal de courant électrique fourni par le réseau d'alimentation électrique est dissymétrique, c'est-à-dire que le signal de courant électrique n'oscille pas de manière équirépartie autour de la valeur nulle. Cette dissymétrie entraîne une composante continue, qui est alors intrinsèque au signal fourni. En suivant l'approche consistant à déterminer une moyenne du signal de courant électrique et à retirer cette moyenne déterminée du calcul de l'énergie consommée, le compteur électrique se retrouve à ne pas prendre en compte, dans le calcul de l'énergie consommée, la composante continue intrinsèque au signal. Or cette composante continue intrinsèque au signal doit faire partie intégrante du calcul de l'énergie consommée, contrairement à la composante continue intrinsèque au compteur électrique, en particulier pour le calcul de l'énergie apparente.

Il est souhaitable de pallier ces différents inconvénients de l'état de la technique.

Il est notamment souhaitable de fournir une solution qui permette de déterminer l'énergie électrique consommée par une installation électrique, lorsque le signal de courant électrique peut prendre la forme d'un signal symétrique ou dissymétrique.

Il est notamment souhaitable de fournir une solution qui permette d'obtenir une valeur d'énergie consommée précise, tout en limitant les ressources de traitement (*« processing resources »* en anglais) nécessaires au calcul de cette valeur.

Il est notamment souhaitable de fournir une solution qui soit simple à mettre en oeuvre et à faible coût.

L'invention concerne un procédé de détermination par un compteur électrique d'une énergie électrique consommée par une installation électrique supervisée par ledit compteur électrique, un signal de courant électrique étant fourni au compteur électrique pour alimenter ladite installation électrique. Le procédé est tel que, lors de périodes d'observation du signal de courant électrique par le compteur électrique pendant lesquelles le signal de courant électrique est considéré symétrique, le compteur électrique détermine une composante continue du signal de courant électrique, et détermine l'énergie électrique consommée pendant lesdites périodes d'observation en retirant la composante continue déterminée. Le procédé est en outre tel que, lors de périodes d'observation du signal de courant électrique par le compteur électrique pendant lesquelles ledit signal de courant électrique est considéré dissymétrique, le compteur électrique détermine l'énergie électrique consommée pendant lesdites périodes d'observation en retirant une composante continue déterminée lors d'au moins une période d'observation antérieure pendant laquelle le signal de courant électrique fourni au compteur électrique est symétrique. Ainsi, lorsque le signal de courant électrique est dissymétrique, seule la composante continue intrinsèque au signal est prise en compte pour le calcul de l'énergie consommée, la composante continue intrinsèque au compteur électrique étant retirée de ce calcul.

Selon un mode de réalisation particulier, le compteur électrique détermine ladite composante continue intrinsèque au compteur électrique en effectuant une moyenne du signal de courant électrique uniquement sur lesdites périodes d'observation pendant lesquelles le signal de courant électrique est considéré symétrique. Ainsi, la composante continue intrinsèque au compteur électrique est facilement déterminée.

Selon un mode de réalisation particulier, le compteur électrique détermine si le signal de courant électrique est symétrique ou dissymétrique en déterminant une proportion temporelle, d'une période d'observation en cours, pour laquelle la valeur absolue du signal de courant électrique est inférieure à un premier seuil, et en comparant cette proportion temporelle déterminée à un second seuil. Ainsi, le compteur électrique peut facilement déterminer le caractère symétrique ou dissymétrique du signal de courant électrique.

Selon un mode de réalisation particulier, le compteur électrique détermine un taux de présence du signal de courant électrique et, lorsque le taux déterminé est inférieur à un troisième seuil, le compteur électrique utilise), pour déterminer l'énergie électrique consommée, un sur-échantillonnage du signal de courant électrique. Ainsi, en particulier, lorsque le signal de courant électrique dissymétrique est sporadique, le calcul d'énergie consommée est rendu plus précis.

Selon un mode de réalisation particulier, les second et troisième seuils sont identiques.

Selon un mode de réalisation particulier, lorsque ledit signal de courant électrique a un taux de présence inférieur au troisième seuil, le compteur électrique met à zéro chaque valeur du signal de courant électrique inférieure en absolu à un quatrième seuil. Ainsi, les ressources de traitement nécessaires au calcul d'énergie consommée sont réduites, en limitant le nombre de multiplications à effectuer pour ce calcul, une multiplication par zéro donnant un résultat nul.

Selon un mode de réalisation particulier, les premier et quatrième seuils sont identiques.

Selon un mode de réalisation particulier, le compteur électrique effectuant un échantillonnage du signal de courant électrique, le compteur électrique détermine si le signal de courant électrique est symétrique ou dissymétrique en effectuant, pour une période d'observation en cours, les étapes suivantes : déterminer un premier nombre d'échantillons pour lesquels la valeur signée du signal de courant électrique est supérieure à un cinquième seuil positif; déterminer un second nombre d'échantillons pour lesquels la valeur signée du signal de courant électrique est inférieure à l'opposé du cinquième seuil ; et comparer une différence absolue entre le premier nombre d'échantillons et le second nombre d'échantillons avec un sixième seuil.

Selon un mode de réalisation particulier, le compteur électrique enregistre en mémoire des valeurs de la composante continue déterminée uniquement lors des périodes d'observation du signal de courant électrique par le compteur électrique pendant lesquelles le signal de courant électrique est considéré symétrique, et le compteur électrique utilise au moins une de ces valeurs enregistrées de composante continue pour le calcul de l'énergie consommée à chaque période d'observation. Ainsi, la mise en oeuvre de l'invention est simple.

Selon un mode de réalisation particulier, le compteur électrique détermine l'énergie électrique consommée en retirant la composante continue déterminée lors de la période d'observation précédente si le signal de courant électrique y était considéré symétrique, et si le signal de courant électrique n'y était pas considéré symétrique, en retirant la composante continue déterminée lors d'au moins une période d'observation antérieure pendant laquelle le signal de courant électrique était symétrique, et préférentiellement la composante continue déterminée lors de la dernière période d'observation pendant laquelle le signal de courant électrique était symétrique et qui était elle-même suivie d'une période d'observation pendant laquelle le signal de courant électrique était symétrique.

Selon un mode de réalisation particulier, le compteur électrique détermine l'énergie électrique consommée en retirant la composante continue déterminée lors de la période d'observation du milieu parmi les trois dernières périodes d'observation consécutives pour lesquelles le signal de courant électrique était symétrique. Ainsi, les périodes transitoires où le signal de courant électrique est en partie symétrique et en partie dissymétrique sont prises en compte.

L'invention concerne également un compteur électrique adapté pour déterminer une énergie électrique consommée par une installation électrique supervisée par ledit compteur électrique, un signal de courant électrique étant destiné à être fourni au compteur électrique pour alimenter ladite installation électrique. Le compteur électrique est tel que, lors de périodes d'observation du signal de courant électrique par le compteur électrique pendant lesquelles le signal de courant électrique est considéré symétrique, le compteur électrique met en oeuvre des moyens pour déterminer une composante continue du signal de courant électrique, et des moyens pour déterminer l'énergie électrique consommée pendant lesdites périodes d'observation en retirant la composante continue déterminée. Le compteur électrique est en outre tel que, lors de périodes d'observation du signal de courant électrique par le compteur électrique pendant lesquelles ledit signal de courant électrique est considéré dissymétrique, le compteur électrique met en oeuvre des moyens pour déterminer l'énergie électrique consommée pendant lesdites périodes d'observation en retirant une composante continue déterminée lors d'au moins une période d'observation antérieure pendant laquelle le signal de courant électrique fourni au compteur électrique est symétrique.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un système électrique dans lequel l'invention peut être mise en oeuvre;

- la Fig. 2 illustre schématiquement un exemple d'architecture matérielle d'un dispositif mettant en oeuvre l'invention ;
- les Figs. 3A, 3B et 3C illustrent schématiquement des formes de signal de courant électrique ;
- la Fig. 4 illustre schématiquement un algorithme de détermination d'énergie consommée ;
- la Fig. 5 illustre schématiquement une succession de périodes d'observation du signal de courant électrique.

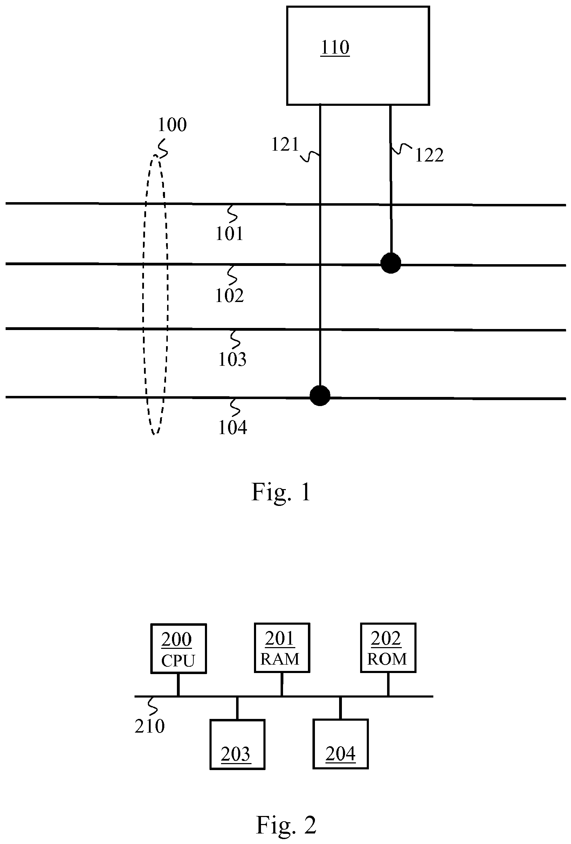

La Fig. 1 illustre schématiquement un système électrique dans lequel l'invention peut être mise en oeuvre.

Le système électrique de la Fig. 1 comporte un réseau d'alimentation électrique 100 constitué d'une pluralité de fils, un fil étant dédié au neutre et au moins un fil étant dédié à au moins une phase. Dans l'exemple de réalisation représenté par la Fig. 1, le réseau d'alimentation électrique 100 est un système à trois phases, et est donc constitué de quatre fils: un fil de neutre 104, un fil d'une première phase 101, un fil d'une seconde phase 102 et un fil de troisième phase 103. La séparation des phases est donc de 120 degrés entre les deux phases, et serait de 180 degrés dans le cas d'un système à deux phases, puisque dans les réseaux électriques polyphasés, les phases sont en général à égale distance angulaire.

Le système électrique de la Fig. 1 pourrait reposer sur un réseau d'alimentation électrique monophasé.

Le système électrique de la Fig. 1 comporte en outre un compteur électrique 110, c'est-à-dire un dispositif servant à mesurer la quantité d'énergie électrique consommée par une installation électrique que le compteur électrique 110 est en charge de superviser. Le compteur électrique 110 est connecté à un des fils de phase du réseau d'alimentation électrique 100 ainsi qu'au fil de neutre, par des liens respectifs 122 et 121. On est, dans ce cas, en présence d'un compteur électrique monophasé. Le système électrique de la Fig. 1 pourrait reposer sur une mise en oeuvre de compteur électrique polyphasé.

Le signal de tension électrique fourni au compteur électrique 110 par le réseau d'alimentation électrique 100 est une sinusoïde centrée autour de la valeur nulle.

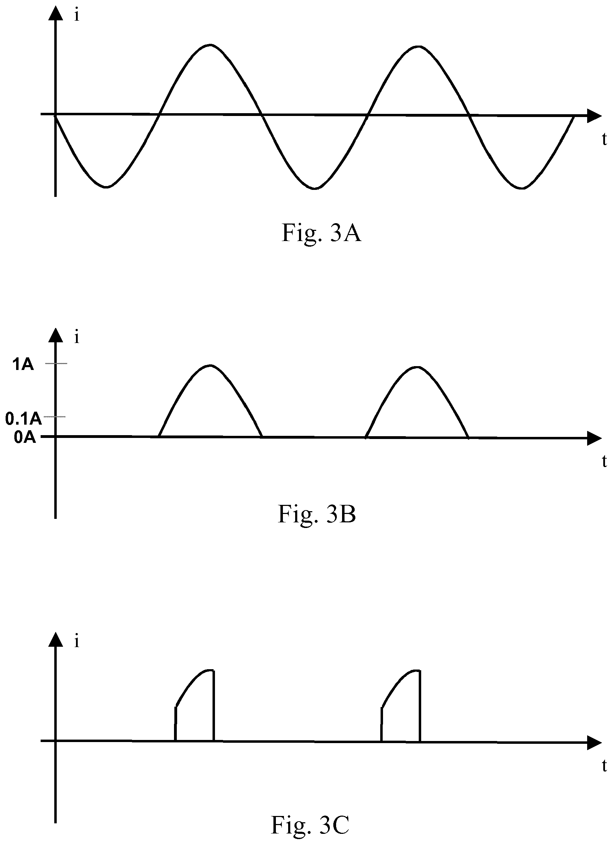

Le signal de courant électrique fourni au compteur électrique 110 par le réseau d'alimentation électrique 100 est le plus souvent aussi une sinusoïde centrée autour de la valeur nulle. Un tel signal est par exemple illustré à la Fig. 3A. Ainsi, lorsque le compteur électrique 110 détermine l'énergie électrique consommée, la seule composante continue du signal de courant électrique que perçoit le compteur électrique 110 est la composante continue intrinsèque au compteur électrique 110 et qui est relative à des étages de conversion analogique-numérique et à des étages d'amplification/atténuation par amplificateur opérationnel. Comme déjà mentionné, il existe des périodes pendant lesquelles le signal de courant électrique fourni au compteur électrique 110 par le réseau d'alimentation électrique 100 est dissymétrique, et éventuellement sporadique. De tels signaux sont par exemple illustrés aux Figs. 3B (signal dissymétrique) et 3C (signal dissymétrique et sporadique). La Fig. 3B représente un signal en demi-onde, c'est-à-dire que par rapport au signal illustré à la Fig. 3A, le signal illustré à la Fig. 3B ne reprend que les portions positives du signal sinusoïdal et est nul le reste du temps. On retrouve une telle forme de signal dans la norme NF-EN 50470-3:2007 « *Equipement de comptage d'électricité (c.a.) - Partie 3: Prescriptions particulières - Compteurs statiques d'énergie active (classes de précision A, B et C)* ». La Fig. 3C représente un signal en « aileron de requin » (« shark dorsal waveform » en anglais), c'est-à-dire que par rapport au signal illustré à la Fig. 3A, le signal illustré à la Fig. 3C ne reprend que des portions de phase du signal sinusoïdal et est nul le reste du temps. Dans l'exemple de la Fig.3C, ce signal est, au vu de la portion de phase sinusoïdale utilisée, toujours positif. Le signal de courant représenté Fig. 3B n'est qu'un exemple illustratif de signal de courant dissymétrique. Le signal de la Fig.3C n'est qu'un exemple illustratif de signal sporadique et dissymétrique. D'autres formes de signaux peuvent être mises en oeuvre pour créer une telle dissymétrie entre les valeurs positives de signal de courant et les valeurs négatives de signal de courant.

La Fig. 2 illustre schématiquement un exemple d'architecture matérielle d'au moins une partie du compteur électrique 110. Le compteur électrique 110 comprend alors, reliés par un bus de communication 210 : un processeur ou CPU (« Central Processing Unit » en anglais) 200 ; une mémoire vive RAM (« Random Access Memory» en anglais) 201 ; une mémoire morte ROM (« Read Only Memory» en anglais) 202 ; une unité de stockage ou un lecteur de support de stockage, tel qu'un lecteur de cartes SD (« Secure Digital » en anglais) 203 ; un ensemble 204 d'interfaces de connexion permettant de connecter le compteur électrique 110 au réseau d'alimentation électrique 100.

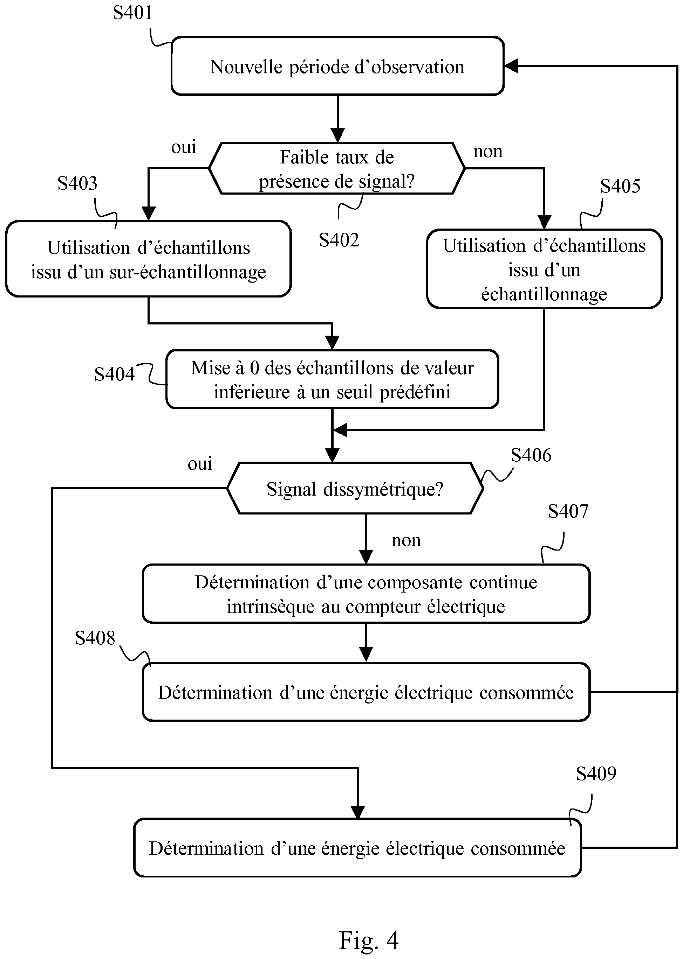

Le processeur 200 est capable d'exécuter des instructions chargées dans la RAM 201 à partir de la ROM 202, d'une mémoire externe (non représentée), d'un support de stockage, tel qu'une carte SD, ou d'un réseau de communication. Lorsque le compteur électrique 110 est mis sous tension, le processeur 200 est capable de lire de la RAM 201 des instructions et de les exécuter. Ces instructions forment un programme d'ordinateur causant la mise en oeuvre, par le processeur 200, de tout ou partie de l'algorithme décrit ci-après en relation avec la Fig. 4.

Tout ou partie de l'algorithme décrit ci-après en relation avec la Fig. 4 peut être implémenté sous forme logicielle par exécution d'un ensemble d'instructions par une machine programmable, tel qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

La Fig. 4 illustre schématiquement un algorithme, mis en oeuvre par le compteur électrique 110, de détermination de l'énergie consommée par l'installation électrique supervisée par le compteur électrique 110.

Dans une étape S401, le compteur électrique 110 étudie une nouvelle période d'observation. Le temps est ainsi découpé en périodes d'observation, de durée préférentiellement prédéfinie, pendant lesquelles le compteur électrique 110 effectue des mesures du signal de courant électrique fourni par le réseau d'alimentation électrique 100 pour alimenter l'installation électrique supervisée par le compteur électrique 110. La durée de chaque période d'observation est un multiple de la période d'oscillation du signal de courant électrique sous forme sinusoïdale. Par exemple, le temps est découpé en périodes d'observation de durée égale à 1 seconde pour une fréquence d'oscillation du signal de courant électrique sous forme sinusoïdale égale à 50 Hz.

Dans une étape S402, le compteur électrique 110 détermine si un taux de présence de signal de courant électrique est supérieur ou pas à un seuil S3. Le signal est dit *présent* lorsque la valeur absolue dudit signal est supérieure à un seuil S4. Si le taux de présence du signal de courant électrique est supérieur au seuil S3, une étape S405 est effectuée ; sinon, c'est-à-dire que le signal de courant électrique a un taux de présence faible, une étape S403 est effectuée.

Dans l'étape S405, le compteur électrique 110 utilise un échantillonnage du signal de courant électrique, c'est-à-dire que le compteur électrique 110 récupère des échantillons du signal de courant électrique issu de cet échantillonnage. Ensuite, une étape S406 est effectuée.

Dans l'étape S403, le compteur électrique 110 utilise un sur-échantillonnage du signal de courant électrique, le sur-échantillonnage ayant un facteur K ≥ 2 par rapport à l'échantillonnage utilisé à l'étape S405. En d'autres termes, le compteur électrique 110 récupère des échantillons du signal de courant électrique issu de ce sur-échantillonnage. Ainsi, le compteur électrique obtient un plus grand nombre d'échantillons sur une même période d'observation.

Dans un mode de réalisation particulier, le compteur électrique 110 utilise le sur-échantillonnage lorsque le compteur électrique 110 détecte que le signal de courant électrique d'une période d'observation est dissymétrique et n'utilise pas le sur-échantillonnage lorsque le compteur électrique 110 détecte que le signal de courant électrique d'une période d'observation est symétrique. En d'autres termes, le seuil S3 est identique à un seuil S2 (défini par la suite en relation avec l'étape S406).

Dans une étape S404 optionnelle suivante, lorsque le signal de courant électrique a un taux de présence faible, le compteur électrique 110 met à zéro les échantillons de valeur absolue inférieure au quatrième seuil S4. Cela permet de limiter l'utilisation de ressources de calcul pour la détermination de l'énergie consommée aux échantillons significatifs. En effet, les échantillons de valeur absolue inférieure au seuil S4 sont considérés comme ayant une incidence négligeable sur la détermination de l'énergie consommée. En forçant les valeurs correspondantes d'échantillons à la valeur nulle, seuls les échantillons considérés comme ayant des valeurs respectives significatives sont pris en compte dans les formules ci-dessus. On notera ainsi que les sommes calculées dans ces formules ne concernent qu'un nombre L d'échantillons, L étant le nombre d'échantillons considérés comme significatifs, avec L < Q, voire L << Q (Q étant le nombre d'échantillons total sur la période).

Préférentiellement, le seuil S4 est identique à un seuil S1 (défini par la suite en relation avec l'étape S406).

Il convient de noter que, dans au moins un mode de réalisation, les étapes S402 à S404 peuvent être omises. Dans ce cas, l'étape S406 est directement effectuée. Dans au moins un autre mode de réalisation, seulement l'étape S404 peut être omise.

Dans l'étape S406, le compteur électrique 110 détermine si, pendant la période d'observation considérée, le signal de courant est dissymétrique. Si tel est le cas une étape S409 est effectuée ; sinon, une étape S407 est effectuée.

Il est, selon un premier critère, possible de détecter si le signal de courant électrique est dissymétrique en déterminant une proportion temporelle de la période d'observation considérée pour laquelle la valeur absolue du signal de courant électrique est inférieure au seuil S1. Le compteur électrique 110 détermine le nombre d'échantillons de la période d'observation considérée dont la valeur absolue est inférieure au seuil S1. Cela donne un taux, sur la période d'observation en cours, représentatif d'une proportion d'un nombre d'échantillons inférieurs au seuil S1 par rapport au nombre d'échantillons total sur la période. Si ce taux est inférieur au seuil S2, alors le compteur électrique 110 estime que le signal de courant électrique est dissymétrique ; sinon, le compteur électrique 110 estime que le signal de courant électrique est symétrique.

Selon un premier exemple, considérons la forme en demi-onde de la Fig. 3B. Ainsi, il existe des périodes d'observation pour lesquelles la forme du signal de courant est en demi-onde et des périodes d'observation pour lesquelles la forme du signal de courant est sinusoïdale. Considérons en outre que le seuil S1 est fixé à 0.1A et que le seuil S2 est fixé à 40%. Le compteur électrique 110 échantillonne alors le signal de courant électrique et détermine le nombre d'échantillons de la période d'observation en cours dont la valeur absolue est inférieure à 0.1A. Si, dans une période d'observation, le compteur électrique 110 détecte plus de 40% d'échantillons dont la valeur absolue est inférieure à 0.1A, le compteur électrique 110 considère être en présence d'un signal dissymétrique ; sinon, le compteur électrique 110 considère être en présence d'un signal symétrique.

Selon un second exemple, considérons la forme en aileron de requin de la Fig. 3C. Ainsi, il existe des périodes d'observation pour lesquelles la forme du signal de courant est en aileron de requin et des périodes d'observation pour lesquelles la forme du signal de courant est sinusoïdale. Il n'est pas nécessaire que la fréquence d'apparition de la forme en aileron de requin soit la même que la fréquence d'oscillation du signal sinusoïdal ; la fréquence d'apparition de la forme en aileron de requin peut être un sous-multiple de la fréquence d'oscillation du signal sinusoïdal. Par exemple, soit T la période du signal sinusoïdal, la forme en aileron de requin apparaît selon une période égale à 15T, et la largeur de la forme en aileron de requin est de 0.1T. Considérons en outre que le seuil S1 est fixé à 1 mA, *i.e.* bien en dessous de la valeur absolue maximale du signal sinusoïdal, et que le seuil S2 est fixé à 85%. Le compteur électrique 110 échantillonne alors le signal de courant électrique et détermine le nombre d'échantillons de la période d'observation en cours dont la valeur absolue est inférieure à 1 mA. Si, dans une période d'observation, le compteur électrique 110 détecte plus de 85% d'échantillons dont la valeur absolue est inférieure à 1 mA, le compteur électrique 110 considère être en présence d'un signal dissymétrique; sinon, le compteur électrique 110 considère être en présence d'un signal symétrique.

Il existe des périodes d'observation, que l'on pourrait qualifier de *transitoires,* pour lesquelles la forme du signal est en demi-onde sur une partie de ces périodes d'observation et sinusoïdal sur le reste de ces périodes d'observation. La valeur à laquelle est fixé le seuil S2 permet de décider de traiter ces périodes transitoires soit en tant que périodes d'observation pendant lesquelles le signal de courant électrique est considéré comme totalement symétrique, ou au contraire en tant que périodes d'observation pendant lesquelles le signal de courant électrique est considéré comme totalement dissymétrique.

Il est aussi possible, selon un second critère, de détecter si le signal de courant électrique est dissymétrique en déterminant, pour la période d'observation considérée, un premier nombre d'échantillons pour lesquels la valeur signée du signal de courant électrique est supérieure à un seuil S1' positif et en déterminant, pour la période d'observation considérée, un second nombre d'échantillons pour lesquels la valeur signée du signal de courant électrique est inférieure à l'opposé du seuil S1' (c'est-à-dire -S1'), et en comparant une différence absolue entre le premier nombre d'échantillons et le second nombre d'échantillons avec un seuil S2'. Si cette différence est supérieure au seuil S2', alors le compteur électrique 110 considère que le signal de courant électrique est dissymétrique ; sinon, le compteur électrique 110 considère que le signal de courant électrique est symétrique.

Il est également possible de mettre en oeuvre un mécanisme de détection de dissymétrie du signal de courant électrique selon le premier critère et un mécanisme de détection de dissymétrie du signal de courant électrique selon le second critère. Le signal de courant électrique est alors considéré dissymétrique lorsque le premier critère et/ou le second critère est respecté..

Dans l'étape S407, le compteur électrique 110 détermine une composante continue du signal de courant électrique intrinsèque au compteur électrique 110. En d'autres termes, le signal de courant électrique tel que vu par le compteur électrique 110 diffère du signal de courant électrique tel que fourni par le réseau d'alimentation électrique 100 en ce que des étages de conversion analogique-numérique et/ou des étages d'amplification/atténuation à base d'amplificateur opérationnel du compteur électrique induisent une composante continue, qui est alors intrinsèque au compteur électrique 110.

Selon un mode de réalisation particulier, le compteur électrique 110 détermine cette composante continue en effectuant une moyenne du signal de courant électrique sur la période d'observation en cours. En référençant $I_{offset}$ cette composante continue, on obtient :

$$I_{offset} = \frac{1}{N} \sum_{n=0}^{N-1} i_n$$

avec *N* le nombre d'échantillons $i_n$ du signal de courant électrique obtenus par le compteur électrique 110 sur la période d'observation en cours, et *n* un index sur les échantillons $i_n$ obtenus.

Le compteur électrique 110 enregistre en mémoire la valeur de la composante continue $I_{offset}$ déterminée à l'étape S407. Préférentiellement, le compteur électrique 110 dispose également en mémoire au moins de la valeur de la composante continue $I_{offset}$ enregistrée lors de la dernière occurrence de l'étape S407, voire de plusieurs autres occurrences de l'étape S407 (c'est-à-dire de périodes d'observation pour lesquelles le signal de courant électrique est symétrique).

Dans un mode de réalisation particulier, les valeurs de composante continue $I_{offset}$ à mémoriser correspondent aux trois dernières périodes d'observation consécutives pour lesquelles le signal de courant électrique est symétrique (strictement antérieures à la période d'observation considérée), en plus de la valeur de composante continue $I_{offset}$ pour la période d'observation considérée si le signal de courant électrique y est symétrique, et des deux dernières périodes d'observation qui précèdent la période d'observation considérée, si le signal de courant électrique y était symétrique.

Un emplacement mémoire non volatil est préférentiellement utilisé, de manière à permettre au compteur électrique 110 d'avoir au moins une valeur du paramètre $I_{offset}$ à utiliser pour le calcul de l'énergie consommée, lorsque, suite à une coupure d'alimentation, le système redémarre avec un signal de courant électrique dissymétrique.

Cette valeur de composante continue $I_{offset}$ pourrait ne pas être déterminée à chaque période d'observation pour laquelle le signal est symétrique. En effet, bien que cette valeur puisse évoluer dans le temps, notamment en fonction des variations de température ambiante autour du compteur électrique 110, cela dépend de la capacité de variation de cette valeur au vu de la durée de chaque période d'observation.

Dans une étape S408 suivante, le compteur électrique 110 détermine l'énergie électrique consommée par l'installation électrique supervisée par le compteur électrique 110 pendant la période d'observation considérée, en retirant la composante continue déterminée lors d'une occurrence antérieure de l'étape S407.

Préférentiellement, le compteur électrique 110 détermine cette énergie électrique consommée en retirant la composante continue déterminée lors de la période d'observation précédente si le signal de courant électrique y était symétrique, et si le signal de courant électrique n'était pas symétrique pendant la période d'observation précédente, en retirant la composante continue déterminée lors d'au moins une période d'observation antérieure pendant laquelle le signal de courant électrique était symétrique, et préférentiellement la composante continue déterminée lors de la dernière période d'observation pendant laquelle le signal de courant électrique était symétrique et qui était elle-même suivie d'une période d'observation pendant laquelle le signal de courant électrique était symétrique.

Dans un autre mode de réalisation, le compteur électrique 110 détermine cette énergie électrique consommée en retirant la composante continue déterminée lors de la période d'observation du milieu parmi les trois dernières périodes d'observation consécutives (strictement antérieures à la période d'observation considérée) pour lesquelles le signal de courant électrique était symétrique.

Ensuite, l'étape S401 est réitérée pour une nouvelle période d'observation.

Le compteur électrique 110 peut déterminer, en ce qui concerne le signal de tension électrique et ce d'une manière similaire au signal de courant électrique, une composante continue intrinsèque au compteur électrique 110. En référençant $U_{offset}$ cette composante continue, on obtient :

$$U_{offset} = \frac{1}{P} \sum_{p=0}^{P-1} u_p$$

avec $P$ le nombre d'échantillons $u_p$ du signal de tension électrique obtenus par le compteur électrique 110 sur la période d'observation en cours, et $p$ un index sur les échantillons $u_p$ obtenus, $P$ étant préférentiellement égal à $N$.

Le compteur électrique 110 peut alors déterminer, à titre d'exemple, l'énergie électrique active consommée, sur la base de l'expression de puissance active suivante :

$$\frac{1}{Q} \sum_{q=0}^{Q-1} \left( (u_q - U_{offset})(i_q - I_{offset}) \right)$$

avec Q le nombre d'échantillons $i_q$ du signal de courant électrique obtenus par le compteur électrique 110 sur la période d'observation en cours, Q étant aussi le nombre d'échantillons $u_q$ du signal de tension électrique obtenus par le compteur électrique 110 sur la période d'observation en cours et $q$ un index sur les échantillons $i_q$ et $u_q$ obtenus.

Le compteur électrique 110 peut aussi déterminer, à titre d'exemple, l'énergie électrique apparente consommée, sur la base de l'expression de puissance apparente suivante :

$$\sqrt{\frac{1}{Q} \sum_{q=0}^{Q-1} (u_q - U_{offset})^2} \cdot \sqrt{\frac{1}{Q} \sum_{q=0}^{Q-1} (i_q - I_{offset})^2}$$

avec les mêmes notations que précédemment.

Dans l'étape S409, le compteur électrique 110 détermine l'énergie électrique consommée par l'installation électrique supervisée par le compteur électrique 110 pendant la période d'observation considérée, en retirant une composante continue déterminée pour au moins une période d'observation précédente pendant laquelle ledit signal de courant électrique est considéré symétrique. En d'autres termes, le paramètre $I_{offset}$ n'est pas calculé pour les périodes d'observation pendant lesquelles le signal de courant électrique est dissymétrique ; le résultat du calcul du paramètre $I_{offset}$ pour au moins une période d'observation pendant lesquelles le signal de courant électrique est symétrique est alors utilisé.

Dans un mode de réalisation particulier, le compteur électrique 110 obtient la valeur du paramètre $I_{offset}$ à utiliser en lisant le ou les emplacements mémoire utilisés à l'étape S407 pour mémoriser la valeur du paramètre $I_{offset}$ lors des périodes d'observation pendant lesquelles le signal de courant électrique est symétrique.

Ainsi, lorsque le signal de courant électrique est dissymétrique, le compteur électrique 110 ne détermine pas la composante continue en faisant la moyenne du signal de courant électrique sur la période d'observation considérée, contrairement au calcul d'énergie consommée effectué à l'étape S407. En effet, si le compteur électrique procédait ainsi, cela entraînerait que la composante continue intrinsèque au signal fourni par le réseau d'alimentation électrique 100 serait aussi retirée du calcul d'énergie consommée, ce qui n'est pas souhaitable. En ne recalculant pas le paramètre $I_{offset}$ pour les périodes d'observation pendant lesquelles le signal de courant électrique est dissymétrique, le compteur électrique 110 assure que seule la composante continue intrinsèque au compteur électrique 110 est retirée du calcul d'énergie consommée.

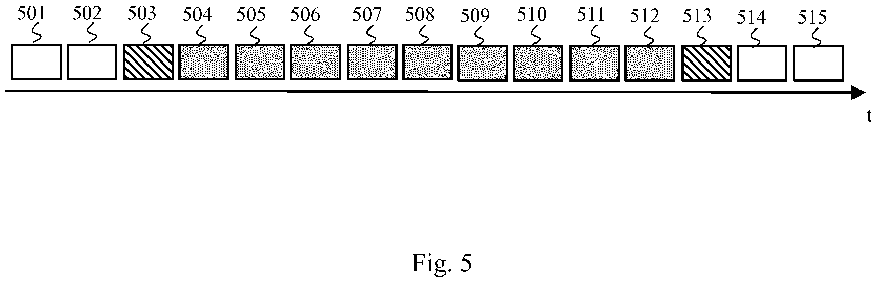

Prenons l'exemple illustré à la Fig. 5, qui représente une succession de périodes d'observation 501 à 515 du signal de courant électrique. Pendant les périodes d'observation 501 et 502, le signal de courant électrique est symétrique. Il en est de même pour les périodes d'observation 514 et 515. Les périodes d'observation 503 et 513 sont des périodes transitoires, pour lesquelles, bien que le signal soit vu statistiquement comme symétrique, il peut comporter une partie symétrique et une partie dissymétrique. Il est donc plus judicieux de ne pas prendre en compte la composante continue calculée sur ces périodes pour le calcul d'énergie consommée des périodes ultérieures. Pendant les périodes d'observation 504 à 512, le signal de courant électrique est dissymétrique, par exemple sous la forme d'un signal sporadique en aileron de requin comme représenté à la Fig. 3C. Alors, le compteur électrique détermine le paramètre $I_{offset}$ pendant les périodes d'observation 501, 502, 514 et 515. Pour déterminer l'énergie consommée pendant les périodes d'observation 503 à 513, le compteur électrique 110 utilise la valeur du paramètre $I_{offset}$ déterminée pendant au moins l'une des périodes d'observation 501, 502, ou au moins l'une des périodes d'observation antérieures pendant laquelle le signal de courant électrique était symétrique, pour effectuer le calcul d'énergie consommée. Préférentiellement, le compteur électrique 110 utilise la valeur du paramètre $I_{offset}$ déterminée pendant la période d'observation 502, afin d'avoir l'information de composante continue intrinsèque au compteur électrique 110 la plus à jour possible, et ne correspondant préférentiellement pas une période transitoire.

Le compteur électrique 110 peut donc utiliser, pour chaque période d'observation pendant laquelle le signal de courant électrique est dissymétrique, la valeur du paramètre $I_{offset}$ calculée sur une période d'observation antérieure pendant laquelle le signal de courant électrique était symétrique, et préférentiellement la valeur du paramètre $I_{offset}$ calculée sur la dernière période d'observation pour laquelle le signal de courant électrique était symétrique et qui était elle-même suivie d'une période d'observation pour laquelle le signal de courant électrique était symétrique, ce qui évite ainsi d'utiliser la composante continue déterminée lors d'une période transitoire.

Le compteur électrique 110 peut aussi utiliser, pour chaque période d'observation pendant laquelle le signal de courant électrique est dissymétrique, les valeurs du paramètre $I_{offset}$ calculées sur plusieurs périodes d'observation antérieures respectives pendant lesquelles le signal de courant électrique était symétrique, par exemple en faisant une moyenne de ces valeurs du paramètre $I_{offset}$ ou en faisant une extrapolation de ces valeurs du paramètre $I_{offset}$.

Comme déjà mentionné, pour éviter toute période transitoire, dans une variante de réalisation, la composante continue à retirer est celle correspondant à la période du milieu des trois dernières périodes d'observation consécutives (strictement antérieures à la période d'observation considérée) pour lesquelles le signal de courant électrique était symétrique. A noter qu'alors, au tout premier démarrage du compteur, les composantes continues des périodes antérieures, bien que n'ayant pas pu être déterminées grâce à des mesures, sont initialisés à 0 et ces périodes d'observation sont considérées comme étant à signal de courant électrique symétrique. Ainsi, si le compteur électrique 110 démarre par une période d'observation pour laquelle le signal de courant électrique est dissymétrique, le compteur électrique 110 peut soustraire une composante continue nulle pour le calcul d'énergie consommée.

Dans un mode de réalisation particulier, le compteur électrique 110 n'utilise pas pour la période d'observation considérée la composante continue déterminée lors de cette période pour le calcul de l'énergie consommée, car cette période d'observation est peut-être transitoire sans que le compteur électrique 110 ne le sache encore (le compteur électrique 110 peut ne le savoir qu'à compter de la période d'observation suivante, pour laquelle le signal de courant électrique sera dissymétrique).

Dans le cas d'un compteur électrique polyphasé, les calculs d'énergie consommée effectués au cours de l'algorithme de la Fig. 4 sont effectués pour chacune des phases auxquelles le compteur électrique 110 est connecté. Le compteur électrique 110 est alors en mesure de déterminer une énergie totale consommée par l'installation électrique supervisée par le compteur électrique 110, en sommant les énergies consommées pour chacune des phases auxquelles le compteur électrique 110 est connecté.

**Revendications**

1.  Procédé de détermination par un compteur électrique (110) d'une énergie électrique consommée par une installation électrique supervisée par ledit compteur électrique, un signal de courant électrique étant fourni au compteur électrique pour alimenter ladite installation électrique, le signal de courant électrique pouvant être symétrique ou dissymétrique,
    le procédé étant tel que, lors de périodes d'observation (502, 514) du signal de courant électrique par le compteur électrique pendant lesquelles le signal de courant électrique est considéré symétrique, le compteur électrique détermine (S407) une composante continue du signal de courant électrique, et détermine (S408) l'énergie électrique consommée pendant lesdites périodes d'observation en retirant la composante continue déterminée ;
    le procédé étant **caractérisé en ce que**, lors de périodes d'observation (504, 505) du signal de courant électrique par le compteur électrique pendant lesquelles ledit signal de courant électrique est considéré dissymétrique, le compteur électrique détermine (S409) l'énergie électrique consommée pendant lesdites périodes d'observation en retirant une composante continue déterminée lors d'au moins une période d'observation antérieure pendant laquelle le signal de courant électrique fourni au compteur électrique est symétrique.

2.  Procédé selon la revendication 1, **caractérisé en ce que** le compteur électrique détermine ladite composante continue intrinsèque au compteur électrique en effectuant une moyenne du signal de courant électrique uniquement sur lesdites périodes d'observation pendant lesquelles le signal de courant électrique est considéré symétrique.

3.  Procédé selon l'une quelconque des revendications 1 et 2, **caractérisé en ce que** le compteur électrique détermine si le signal de courant électrique est symétrique ou dissymétrique en déterminant une proportion temporelle, d'une période d'observation en cours, pour laquelle la valeur absolue du signal de courant électrique est inférieure à un premier seuil, et en comparant cette proportion temporelle déterminée à un second seuil.

4.  Procédé selon l'une quelconque des revendications 1 à 3, **caractérisé en ce que** le compteur électrique détermine (S402) un taux de présence du signal de courant électrique et, lorsque le taux déterminé est inférieur à un troisième seuil, le compteur électrique utilise (S403), pour déterminer l'énergie électrique consommée, un sur-échantillonnage du signal de courant électrique.

5.  Procédé selon la revendication 4, **caractérisé en ce que** les second et troisième seuils sont identiques.

6.  Procédé selon l'une quelconque des revendications 4 et 5, **caractérisé en ce que**, lorsque ledit signal de courant électrique a un taux de présence inférieur au troisième seuil, le compteur électrique met à zéro (S404) chaque valeur du signal de courant électrique inférieure en absolu à un quatrième seuil.

7.  Procédé selon la revendication 6, **caractérisé en ce que** les premier et quatrième seuils sont identiques.

8.  Procédé selon l'une quelconque des revendications 1 à 7, **caractérisé en ce que**, le compteur électrique effectuant un échantillonnage du signal de courant électrique, le compteur électrique détermine si le signal de courant électrique est symétrique ou dissymétrique en effectuant, pour une période d'observation en cours, les étapes suivantes :

    - déterminer un premier nombre d'échantillons pour lesquels la valeur signée du signal de courant électrique est supérieure à un cinquième seuil positif;
    - déterminer un second nombre d'échantillons pour lesquels la valeur signée du signal de courant électrique est inférieure à l'opposé du cinquième seuil ; et
    - comparer une différence absolue entre le premier nombre d'échantillons et le second nombre d'échantillons avec un sixième seuil.

9.  Procédé selon l'une quelconque des revendications 1 à 8, **caractérisé en ce que** le compteur électrique enregistre en mémoire des valeurs de la composante continue déterminées uniquement lors des périodes d'observation du signal de courant électrique par le compteur électrique pendant lesquelles le signal de courant électrique est considéré symétrique, et le compteur électrique utilise au moins une de ces valeurs enregistrées de composante continue pour le calcul de l'énergie consommée à chaque période d'observation.

10. Procédé selon la revendication 9, **caractérisé en ce que** le compteur électrique détermine l'énergie électrique consommée en retirant la composante continue déterminée lors de la période d'observation précédente si le signal de courant électrique y était considéré symétrique, et si le signal de courant électrique n'y était pas considéré symétrique, en retirant la composante continue déterminée lors d'au moins une période d'observation antérieure pendant laquelle le signal de courant électrique était symétrique, et préférentiellement la composante continue déterminée lors de la dernière période d'observation pendant laquelle le signal de courant électrique était symétrique et qui était elle-même suivie d'une période d'observation pendant laquelle le signal de courant électrique était symétrique.

11. Procédé selon la revendication 9, **caractérisé en ce que** le compteur électrique détermine l'énergie électrique consommée en retirant la composante continue déterminée lors de la période d'observation du milieu parmi les trois dernières périodes d'observation consécutives pour lesquelles le signal de courant électrique était symétrique.

12. Programme d'ordinateur, **caractérisé en ce qu'**il comprend des instructions pour mettre en oeuvre, par un compteur électrique, le procédé selon l'une quelconque des revendications 1 à 11, lorsque ledit programme est exécuté par un processeur dudit compteur électrique.

13. Moyens de stockage, **caractérisés en ce qu'**ils stockent le programme d'ordinateur selon la revendication 12.

14. Compteur électrique (110) adapté pour déterminer une énergie électrique consommée par une installation électrique supervisée par ledit compteur électrique, un signal de courant électrique étant destiné à être fourni au compteur électrique pour alimenter ladite installation électrique, le signal de courant électrique pouvant être symétrique ou dissymétrique,
le compteur électrique étant tel que, lors de périodes d'observation (502, 514) du signal de courant électrique par le compteur électrique pendant lesquelles le signal de courant électrique est considéré symétrique, le compteur électrique implémente des moyens pour déterminer (S407) une composante continue du signal de courant électrique, et des moyens pour déterminer (S408) l'énergie électrique consommée pendant lesdites périodes d'observation en retirant la composante continue déterminée ;
le compteur électrique étant **caractérisé en ce que**, lors de périodes d'observation (504, 505) du signal de courant électrique par le compteur électrique pendant lesquelles ledit signal de courant électrique est considéré dissymétrique, le compteur électrique implémente des moyens pour déterminer (S409) l'énergie électrique consommée pendant lesdites périodes d'observation en retirant une composante continue déterminée lors d'au moins une période d'observation antérieure pendant laquelle le signal de courant électrique fourni au compteur électrique est symétrique.

**Patentansprüche**

1. Verfahren zum Ermitteln einer von einer von einem Stromzähler überwachten elektrischen Anlage verbrauchten elektrischen Energie durch den Stromzähler (110), wobei ein elektrisches Stromsignal an den Stromzähler zum Versorgen der elektrischen Anlage geliefert wird, wobei das elektrische Stromsignal symmetrisch oder asymmetrisch sein kann,
wobei das Verfahren so ausgebildet ist, dass in Perioden der Beobachtung (502, 514) des elektrischen Stromsignals durch den Stromzähler, in denen das elektrische Stromsignal als symmetrisch zu betrachten ist, der Stromzähler eine kontinuierliche Komponente des elektrischen Stromsignals ermittelt (S407) und die in den Beobachtungsperioden verbrauchte elektrische Energie durch Abziehen der ermittelten kontinuierlichen Komponente ermittelt (S408);
wobei das Verfahren **dadurch gekennzeichnet ist, dass** in Perioden der Beobachtung (504, 505) des elektrischen Stromsignals durch den Stromzähler, in denen das elektrische Stromsignal als asymmetrisch zu betrachten ist, der Stromzähler den in den Beobachtungsperioden verbrauchten elektrischen Strom durch Abziehen einer in wenigstens einer vorhergehenden Beobachtungsperiode, in der das an den Stromzähler gelieferte elektrische Stromsignal symmetrisch ist, ermittelten kontinuierlichen Komponente ermittelt (S409).

2. Verfahren nach Anspruch 1, **dadurch gekennzeichnet, dass** der Stromzähler die im Stromzähler intrinsische kontinuierliche Komponente durch Ermitteln eines Durchschnitts des elektrischen Stromsignals ausschließlich in den Beobachtungsperioden, in denen das elektrische Stromsignal als symmetrisch zu betrachten ist, ermittelt.

3. Verfahren nach einem der Ansprüche 1 und 2, **dadurch gekennzeichnet, dass** der Stromzähler ermittelt, ob das elektrische Stromsignal symmetrisch oder asymmetrisch ist, indem er einen zeitlichen Anteil einer laufenden Beobachtungsperiode ermittelt, in dem der Absolutwert des elektrischen Stromsignals unter einer ersten Schwelle liegt, und diesen ermittelten zeitlichen Anteil mit einer zweiten Schwelle vergleicht.

4.  Verfahren nach einem der Ansprüche 1 bis 3, **dadurch gekennzeichnet, dass** der Stromzähler eine Rate des Vorhandenseins des elektrischen Stromsignals ermittelt (S402) und, wenn die ermittelte Rate unter einer dritten Schwelle liegt, der Stromzähler zum Ermitteln der verbrauchten elektrischen Energie eine Übertastung des elektrischen Stromsignals verwendet (S403).

5.  Verfahren nach Anspruch 4, **dadurch gekennzeichnet, dass** zweite und dritte Schwelle identisch sind.

6.  Verfahren nach einem der Ansprüche 4 und 5, **dadurch gekennzeichnet, dass**, wenn das elektrische Stromsignal eine Rate des Vorhandenseins unter der dritten Schwelle aufweist, der Stromzähler jeden Wert des elektrischen Stromsignals unterhalb absolut einer vierten Schwelle auf Null setzt (S404).

7.  Verfahren nach Anspruch 6, **dadurch gekennzeichnet, dass** erste und vierte Schwelle identisch sind.

8.  Verfahren nach einem der Ansprüche 1 bis 7, **dadurch gekennzeichnet, dass** bei einer Abtastung des elektrischen Stromsignals durch den Stromzähler der Stromzähler ermittelt, ob das elektrische Stromsignal symmetrisch oder asymmetrisch ist, indem er in einer laufenden Beobachtungsperiode die folgenden Schritte durchführt:

    - Ermitteln einer ersten Zahl von Stichproben, bei denen der Wert mit Vorzeichen des elektrischen Stromsignals größer ist als eine fünfte positive Schwelle;
    - Ermitteln einer zweiten Zahl von Stichproben, bei denen der Wert mit Vorzeichen des elektrischen Stromsignals kleiner ist entgegengesetzt zur fünften Schwelle; und
    - Vergleichen eines absoluten Unterschieds zwischen der ersten Zahl von Stichproben und der zweiten Zahl von Stichproben mit einer sechsten Schwelle.

9.  Verfahren nach einem der Ansprüche 1 bis 8, **dadurch gekennzeichnet, dass** der Stromzähler im Speicher ausschließlich in Perioden der Beobachtung des elektrischen Stromsignals durch den Stromzähler, in denen das elektrische Stromsignal als symmetrisch zu betrachten ist, ermittelte Werte der kontinuierlichen Komponente speichert und der Stromzähler wenigstens einen der gespeicherten Werte der kontinuierlichen Komponente zur Berechnung der verbrauchten Energie in jeder Beobachtungsperiode verwendet.

10. Verfahren nach Anspruch 9, **dadurch gekennzeichnet, dass** der Stromzähler die verbrauchte elektrische Energie durch Abziehen der in der vorhergehenden Beobachtungsperiode ermittelten kontinuierlichen Komponente ermittelt, wenn das elektrische Stromsignal dort als symmetrisch zu betrachten war, und wenn das elektrische Stromsignal dort nicht als symmetrisch zu betrachten war, durch Abziehen der in wenigstens einer vorhergehenden Beobachtungsperiode, in der das elektrische Stromsignal symmetrisch war, ermittelten kontinuierlichen Komponente, und vorzugsweise der in der letzten Beobachtungsperiode, in der das elektrische Stromsignal symmetrisch war und auf die selbst eine Beobachtungsperiode folgte, in der das elektrische Stromsignal symmetrisch war, ermittelten kontinuierlichen Komponente.

11. Verfahren nach Anspruch 9, **dadurch gekennzeichnet, dass** der Stromzähler die verbrauchte elektrische Energie durch Abziehen der in der Beobachtungsperiode der Mitte zwischen den drei letzten aufeinander folgenden Beobachtungsperioden, bei denen das elektrische Stromsignal symmetrisch war, ermittelten kontinuierlichen Komponente ermittelt.

12. Computerprogramm, **dadurch gekennzeichnet, dass** es Anweisungen umfasst, um durch einen Stromzähler das Verfahren nach einem der Ansprüche 1 bis 11 auszuführen, wenn das Programm von einem Prozessor des Stromzählers ausgeführt wird.

13. Speichermittel, **dadurch gekennzeichnet, dass** sie das Programm nach Anspruch 12 speichern.

14. Zum Ermitteln einer von einer von einem Stromzähler überwachten elektrischen Anlage verbrauchten elektrischen Energie ausgebildeter Stromzähler (110), wobei ein elektrisches Stromsignal ausgebildet ist, an den Stromzähler zum Versorgen der elektrischen Anlage geliefert zu werden, wobei das elektrische Stromsignal symmetrisch oder asymmetrisch sein kann,

    wobei der Stromzähler so ausgebildet ist, dass in Perioden der Beobachtung (502, 514) des elektrischen Stromsignals durch den Stromzähler, in denen das elektrische Stromsignal als symmetrisch zu betrachten ist, der Stromzähler Mittel zum Ermitteln (S407) einer kontinuierlichen Komponente des elektrischen Stromsignals und Mittel zum Ermitteln (S408) der in den Beobachtungsperioden verbrauchten elektrischen Energie durch Abziehen der ermittelten kontinuierlichen Komponente implementiert;
wobei der Stromzähler **dadurch gekennzeichnet ist, dass** in Perioden der Beobachtung (504, 505) des elektrischen Stromsignals durch den Stromzähler, in denen das elektrische Stromsignal als asymmetrisch zu betrachten ist, der Stromzähler Mittel zum Ermitteln (S409) der in den Beobachtungsperioden verbrauchten elektrischen Energie durch Abziehen einer in wenigstens einer vorhergehenden Beobachtungsperiode, in der das an den Stromzähler gelieferte elektrische Stromsignal symmetrisch ist, ermittelten kontinuierlichen Komponente implementiert.

**Claims**

1. Method for determining by an electric meter (110) an electrical energy consumed by an electrical installation supervised by said electric meter, an electric current signal being supplied to the electric meter for supplying said electrical installation, the electrical signal being able to be symmetrical or asymmetrical,
the method being such that, during periods of observation (502, 514) of the electrical current signal by the electric meter during which the electric current signal is considered to be symmetrical, the electrical meter determines (S407) a continuous component of the signal of electric current, and determines (S408) the electrical energy consumed during said observation periods by removing the determined continuous component;
the method being **characterized in that**, during periods of observation (504, 505) of the electric current signal by the electric meter during which said electric current signal is considered asymmetrical, the electric meter determines (S409) the electrical energy consumed during said observation periods by removing a determined DC component during at least one previous observation period during which the electric current signal supplied to the electric meter is symmetrical.

2. The method according to claim 1, **characterized in that** the electric meter determines said intrinsic continuous component of the electric meter by averaging the electric current signal only on said observation periods during which the electric current signal is considered symmetrical.

3. The method according to any one of claims 1 and 2, **characterized in that** the electric meter determines whether the electric current signal is symmetrical or asymmetrical by determining a temporal proportion, of a current observation period, for which the absolute value of the electric current signal is less than a first threshold, and by comparing this determined temporal proportion to a second threshold.

4. The method according to any one of claims 1 to 3, **characterized in that** the electrical meter determines (S402) a presence rate of the electric current signal and, when the determined rate is lower than a third threshold, the electric meter uses (S403), for determining the electrical energy consumed, an oversampling of the electric current signal.

5. The method according to claim 4, **characterized in that** the second and third thresholds are identical.

6. The method according to any of claims 4 and 5, **characterized in that**, when said electric current signal has a presence rate lower than the third threshold, the electric meter sets (S404) each value of the lower electric current signal in absolute terms to a fourth threshold.

7. The method according to claim 6, **characterized in that** the first and fourth thresholds are identical.

8. The method according to any one of claims 1 to 7, **characterized in that** the electric meter performing a sampling of the electric current signal, the electric meter determines whether the electrical current signal is symmetrical or asymmetrical by performing, for a period of observation in progress, the following steps:

   - determining a first number of samples for which the signed value of the electric current signal is greater than a fifth positive threshold;
   - determining a second number of samples for which the signed value of the electrical current signal is less than the opposite of the fifth threshold; and
   - comparing an absolute difference between the first number of samples and the second number of samples with a sixth threshold.

9. The method according to any one of claims 1 to 8, **characterized in that** the electrical meter stores in memory values of the continues component determined only during periods of observation of the electrical current signal by the electric meter during which the signal of electrical current is considered symmetrical, and the electric meter uses at least one of these recorded values of continuous component for calculating the energy consumed at each observation period.

10. The method according to claim 9, **characterized in that** the electric meter determines the electrical energy consumed by removing the continuous component determined during the previous observation period if the electric current signal was considered symmetrical, and if the electric current was not considered symmetrical, by removing the continuous component determined during at least one previous observation period during which the electrical current signal was symmetrical, and preferably the continuous component determined during the last period of observation during which the electric current signal was symmetrical and which was itself followed by a period of observation during which the electric current signal was symmetrical.

11. The method according to claim 9, **characterized in that** the electric meter determines the electrical energy consumed by removing the DC component determined during the observation period of the medium from the last three consecutive observation periods for which the electric current signal was symmetrical.

12. A computer program, **characterized in that** it comprises instructions for implementing, by an electric meter, the method according to any one of claims 1 to 11, when said program is executed by a processor of said electric meter.

13. Storage means, **characterized in that** they store the computer program according to claim 12.

14. Electric meter (110) adapted to determine an electrical energy consumed by an electrical installation supervised by said electric meter, an electric current signal being intended to be supplied to the electric meter for supplying said electrical installation, the electric current being able to be symmetrical or asymmetrical, the electric meter being such that, during periods of observation (502, 514) of the electric current signal by the electric meter during which the electric current signal is considered to be symmetrical, the electric meter implements means for determining (S407) a continuous component of the electric current signal, and means for determining (S408) the electrical energy consumed during said observation periods by removing the determined DC component; the electric meter being **characterized in that**, during periods of observation (504, 505) of the electrical current signal by the electric meter during which said electric current signal is considered asymmetrical, the electric meter implements means for determining (S409) the electrical energy consumed during said previous observation periods during which the electrical current signal supplied to the electricity meter is symmetrical.

Fig. 1

Fig. 2

Fig. 3A

Fig. 3B

Fig. 3C

S401

Nouvelle période d'observation

oui ⟶ Faible taux de présence de signal? ⟵ non

S402

S403

Utilisation d'échantillons issu d'un sur-échantillonnage

S405

Utilisation d'échantillons issu d'un échantillonnage

S404

Mise à 0 des échantillons de valeur inférieure à un seuil prédéfini

oui ⟵ Signal dissymétrique?

S406

non

S407

Détermination d'une composante continue intrinsèque au compteur électrique

S408

Détermination d'une énergie électrique consommée

S409

Détermination d'une énergie électrique consommée

Fig. 4

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0420545 A

- DE 19842241